# EUROPÄISCHE PATENTSCHRIFT

(11) **EP 1 766 656 B1**
(45) Veröffentlichungstag und Bekanntmachung des Hinweises auf die Patenterteilung: **11.09.2013**
(21) Anmeldenummer: 05740159.8
(22) Anmeldetag: 26.04.2005
(51) Int. Cl.: H01J 37/32, H05H 1/48, C23C 14/32, C23C 14/06

(54) **VORRICHTUNG ZUR KOHLENSTOFFABSCHEIDUNG**
DEVICE FOR CARBON DEPOSITION
DISPOSITIF SERVANT A DEPOSER DU CARBONE

(30) Priorität: 18.06.2004 DE 102004029526
(43) Veröffentlichungstag der Anmeldung: 28.03.2007
(73) Patentinhaber: ROBERT BOSCH GMBH, 70442 Stuttgart (DE)
(72) Erfinder: SCHNEIDER, Günter, 74354 Besigheim (DE); SCHATTKE, Alexander, 70499 Stuttgart (DE); FEUERFEIL, Rainer, 70839 Gerlingen (DE)
(86) Internationale Anmeldenummer: PCT/EP2005/051849
(87) Internationale Veröffentlichungsnummer: WO 2005/124818

(56) Entgegenhaltungen:
- DE-A1- 10 155 120
- RU-C1- 2 153 782
- US-A1- 2003 035 905
- US-B1- 6 355 350

## Beschreibung

### Stand der Technik

Die Erfindung betrifft eine Vorrichtung zur Kohlenstoffabscheidung nach dem Oberbegriff des Anspruchs 1.

Zur Beschichtung von Werkstücken, insbesondere von tribologisch hochbelasteten Komponenten, die gleichzeitig einer zusätzlichen, mehrfachartigen Belastung wie beispielsweise der Temperatur oder der Kavitation unterliegen, sind mehrere physikalische Abscheidungsverfahren bekannt. Aus dem Bereich der Plasmabeschichtungstechnik sind zwei unterschiedliche Verfahren zur Erzeugung von metall- und wasserstofffreien Kohlenstoffschichten (sog. Tetraedrisch koordinierter amorpher Kohlenstoff, ta-C) zu nennen: Abscheidung von Graphittargets durch Sputtern oder durch Bogenverdampfung.

Das Sputter-Verfahren zeichnet sich jedoch durch eine niedrige Depositionsrate aus, weshalb dieses Verfahren für eine wirtschaftliche Nutzung wenig geeignet ist.

Bei einer Bogenverdampfung besteht die Kathode typischerweise aus dem zu verdampfenden Material, während als Anode eine spezielle Elektrode vorhanden ist oder auch die Wand der Beschichtungskammer als Anode dienen kann. Zum Verdampfen des Targetmaterials wird zwischen der Anode und der Kathode ein Lichtbogen gezündet, der die Kathode lokal an dem Brennpunkt, erkennbar an einem Brennfleck auf der Kathode, so stark aufheizt, dass das Targetmaterial in die Dampfphase übergeht und auf einem Werkstück abscheidet. Zur Erzeugung des Lichtbogens zwischen der Anode und der Kathode benötigt man eine Zündvorrichtung.

Neben beweglichen Zündvorrichtungen sind fest in der Nähe der Targetkathode angeordnete Zündelektroden bekannt, zwischen denen ein Lichtbogen gezündet wird, der dann von der Zündelektrode auf die Anode abwandert.

Eine kontrollierte Gleichstrom-(dc-)Bogenverdampfung von Kohlenstoff erweist sich als schwierig, da der Brennpunkt des Lichtbogens dazu tendiert, an einer Stelle des Targets fest- und möglicherweise durchzubrennen. Auch ist es bekannt, dass beim Verdampfen sogenannte Droplets (Makropartikeln) zu einer erhöhten Schichtrauheit auf dem Werkstück führen. Auch dieses Verfahren wird daher nur eingeschränkt eingesetzt.

Bei einer gepulsten Bogenentladung hingegen wird die Spannung zwischen der Anode und der Kathode pulsierend angelegt, wodurch sich der Brennpunkt auf dem Target gegenüber der dc-Bogenverdampfung mit einer ca. 100-fachen Geschwindigkeit bewegt und dadurch das Festbrennen vermieden wird. Die gepulste Bogenentladung hat im allgemeinen eine Pulslänge im Bereich von Millisekunden (msec), dadurch ist die Entladung in der räumlichen Nähe der Zündung lokalisiert.

Will man die Technologie der gepulsten Bogenentladung bei großflächigen Targets einsetzen, ist daher ein Aufbau mit mehreren einzelnen Zündquellen sinnvoll.

Aus der DE 101 55 120 A1 ist eine Zündelektrodenanordnung bekannt, welche Zündsegmente bestehend aus je zwei Elektroden und einem dazwischen angeordneten Isolator aufweist. Die Zündsegmente sind dabei nicht ummantelt.

Aus der RU 2153782 C1 ist eine Kohlenstoffplasma-Impulsquelle zum Auftragen einer Kohlenstoffschicht auf ein Werkstück bekannt, die unter anderem eine Graphitkathode, eine Anode, eine kapazitive Speicherschaltung und mindestens zwei am Umfang der Graphitkathode angeordnete Zündeinheiten aufweist. Durch diese Anordnung wird im Vergleich zu einer Vorrichtung mit nur einer Zündeinheit der mit der Kohlenstoffschicht beschichtete Bereich erweitert und gleichzeitig die Dicke der aufgebrachten Schicht am Werkstück gleichmäßiger. Die Zündeinheiten bestehen jeweils aus einer stabförmigen Metallelektrode und aus einer ringförmigen Graphitelektrode, die jeweils als Zündkathode bzw. Zündanode dienen. Zwischen der Zündkathode und der Zündanode ist ein Ring aus einem dielektrischen Material angeordnet, wobei das dielektrische Material an der der Targetkathode zugewandten Seite mit einem elektrisch leitenden Material beschichtet ist. Die Längsachse jeder Zündeinheit ist dabei auf das entsprechende Gebiet der Arbeitsfläche der Targetkathode gerichtet, welches zum Starten der Lichtbogenentladung vorgesehen ist.

Die ringförmige Struktur der Zündkathode und des dielektrischen Materials kann sich nachteilig auf eine wirtschaftliche und möglichst homogene Ausnutzung der Targetfläche auswirken: Durch die quasi punktförmig wirkende Zündquelle ist der Zündort auf der Targetfläche auf einen relativ kleinen Bereich beschränkt, so dass eine bestimmte Stelle von Entladung zu Entladung abgetragen wird, während die benachbarten Stellen auf der Targetfläche weitgehend unbehandelt bleiben. Mit der Zeit führen solche ausgeprägten Erosionszonen zu unerwünschten Kraterbildungen auf der Targetkathode.

Um dennoch möglichst die gesamte Targetfläche homogen abtragen zu können, müssen die Zündquellen eng nebeneinander angeordnet werden. Folglich steigt die Anzahl der benötigten Zündquellen pro Längeneinheit der Targetkathode, und mit ihr der Wartungsaufwand und die Instabilität bei einem Dauerbetrieb der Beschichtungsanlage.

Ferner ist es zu beachten, dass die Zündeinheiten einer hohen Wärmebelastung ausgesetzt sind und für einen stabilen Dauerbetrieb und/oder hohe Zündfrequenzen gekühlt werden sollten. Bei rundförmigen Zündeinheiten ist ihre Kühlung anlagetechnisch recht aufwendig, da die Kühlvorrichtung bei jeder einzelnen Zündeinheit der ringförmigen Struktur der Elektroden angepasst werden muss und daher entsprechende Rundungen aufweisen sollte.

Insgesamt erschweren die geschilderten Probleme eine einfache und stabile Nutzung des Beschichtungsverfahrens mittels der gepulsten Vakuumbogenentladung bei großflächigen Targets zur wirtschaftlichen Anwendung.

### Vorteile der Erfindung

Die erfindungsgemäße Vorrichtung zur Kohlenstoffabscheidung mit den kennzeichnenden Merkmalen des Anspruchs 1 hat den Vorteil, dass die oben genannten Nachteile beseitigt werden und dadurch eine homogene Verteilung des Zündortes des Lichtbogens auf einer beliebig groß dimensionierten Targetfläche erreicht wird.

Dabei kann die Anlage mit der Vorrichtung auf einfache Weise so stabil und zuverlässig betrieben werden, dass eine industrielle Nutzung ermöglicht wird.

Vorteilhafte Weiterbildungen der erfindungsgemäßen Vorrichtung sind in den Unteransprüchen angegeben. Zeichnung

Ausführungsbeispiele der Erfindung werden anhand der Zeichnung und der nachfolgenden Beschreibung näher erläutert. Es zeigen:
Figur 1 eine Vorrichtung zur Kohlenstoffabscheidung mit ihren wesentlichen Komponenten,
Figur 2 eine erste Zündeinheit in perspektivischer Darstellung,
Figur 3 eine zweite Zündeinheit in perspektivischer Darstellung und
Figur 4 eine Targetkathode in Draufsicht mit einem Kühlwasserkreislauf, einer Basiselektrode und mehreren Zündeinheiten.

### Beschreibung der Ausführungsbeispiele

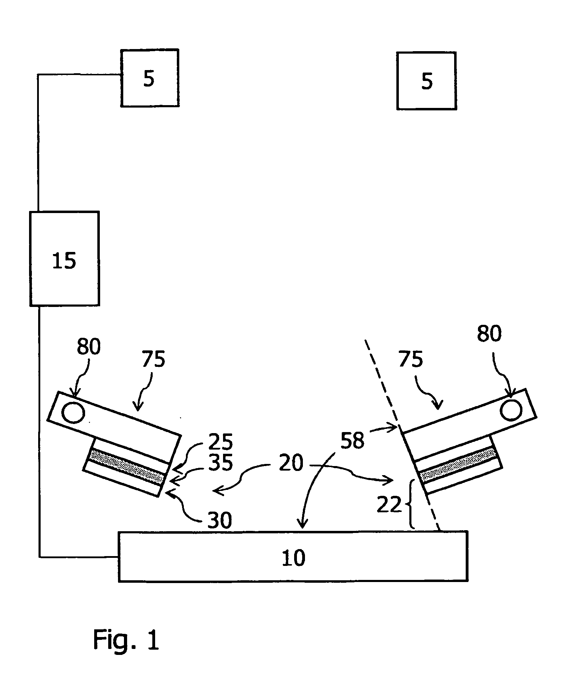

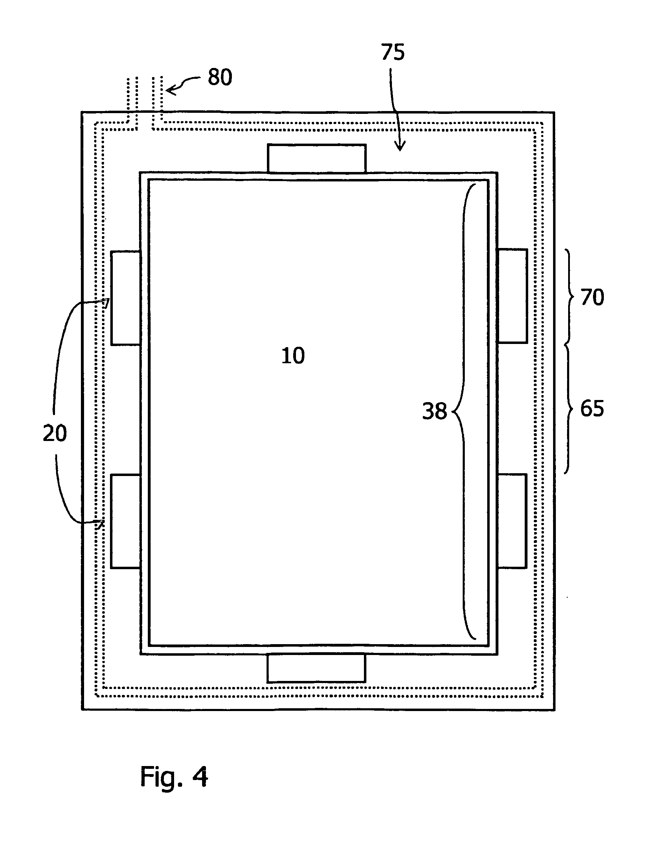

Die in Figur 1 dargestellte Vorrichtung zur Kohlenstoffabscheidung besteht im wesentlichen aus einer Anode 5, einer planaren Targetkathode 10, einer Pulsenergiequelle 15 und aus mindestens zwei Zündeinheiten 20. Die Zündeinheiten 20 sind im Randbereich der Targetkathode 10 angeordnet (siehe auch Figur 4).

Zwischen der aus Kohlenstoff gebildeten Targetkathode 10 und der Anode 5 ist die Pulsenergiequelle 15 geschaltet, die typischerweise als Kondensator ausgebildet ist. Der Kondensator wird über ein nicht dargestelltes Stromnetzteil gespeist und bleibt zunächst geladen, da zwischen der Anode 5 und der Targetkathode 10 ein Vakuum besteht und somit der Stromkreis nicht geschlossen ist. Zur Zündung eines Lichtbogens zwischen der Anode 5 und der Targetkathode 10 und damit zum Kohlenstoffabtrag von der Targetkathode 10 in Richtung zur Anode 5 sind die mindestens zwei Zündeinheiten 20 vorgesehen.

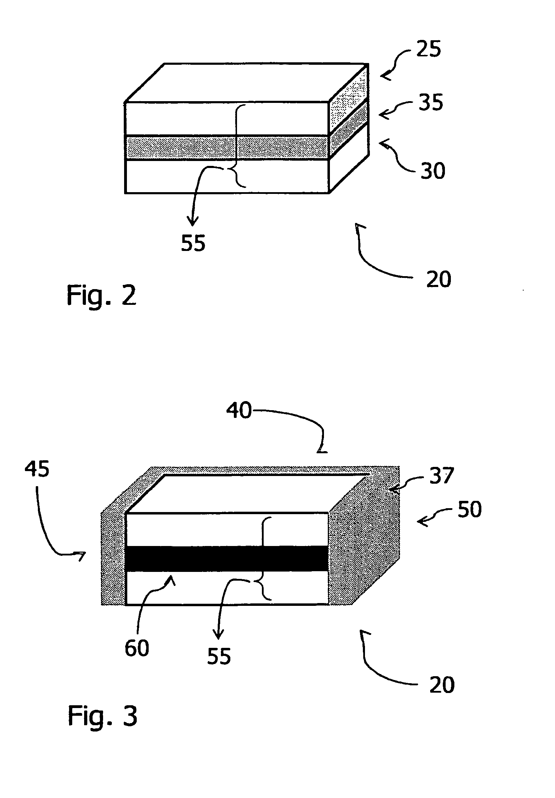

Erfindungsgemäß umfassen die Zündeinheiten 20, wie in Figur 2 dargestellt, jeweils zwei planare, zueinander parallel angeordnete metallische Elektroden 25, 30, wobei im Zwischenraum zwischen den Elektroden 25, 30 eine planare Isolierkeramik 35 angeordnet ist. Die metallischen Elektroden 25, 30 können aus abbrandfesten Materialen wie beispielsweise Wolfram, Wolfram/Lanthan oder auch Graphit bestehen. Die Zündeinheiten 20 sind elektrisch mit einem nicht dargestellten Zündverteiler verbunden, welcher die Zündung der einzelnen Zündeinheiten 20 steuert. Beim Anlegen eines Strompulses mit einer ausreichend hohen Spannung zwischen den beiden Elektroden 25, 30 entsteht eine Glimmentladung, mit der die eigentliche Bogenentladung von der Targetkathode 10 zur Anode 5 entfacht wird.

Durch die planare Gestaltung der Zündeinheit 20 ergibt sich für die Isolierkeramik 35 bei Blick auf die Stirnseite 55 der Zündeinheit 20 eine linear ausgedehnte Fläche in Form eines Rechtecks. Die Länge des Rechtecks ist um ein Vielfaches größer als seine Breite. In der Praxis beträgt die Länge etwa bis zu 10 cm. Zündet man die Zündeinheit 20 mehrere Male hintereinander, so entsteht der Zündfunke bei jeder erneuten Zündung statistisch verteilt an verschiedenen Stellen entlang der linear ausgedehnten Fläche. Somit wird auch der Brennpunkt auf der Targetkathode 10 bei jeder Zündung etwas versetzt. Auf eine einfache Weise wird eine homogene Ausnutzung der Gesamtfläche der Targetkathode 10 erzielt, die schließlich zu einer gleichmäßigen Beschichtung eines Werkstückes führt.

Ein weiterer Vorteil ergibt sich beim Vergleich der notwendigen Anzahl der planaren Zündeinheiten 20 gegenüber der Anzahl der nicht-planaren Zündeinheiten, wie beispielsweise der scheibenförmigen Zündeinheiten. Hat die Targetkathode 10 in beiden Fällen die gleiche Länge 38 (siehe Figur 4), so sind weniger planare Zündeinheiten 20 notwendig, weil jede einzelne planare Zündeinheit 20 eine größere Fläche auf der Targetkathode 10 homogen abträgt. Eine kleinere Anzahl der Zündeinheiten 10 vermindert den Wartungsaufwand und verlängert die Standzeit.

Weiter können die planaren Zündeinheiten 20 aufgrund ihrer Form sehr nahe an der Targetkathode 10 positioniert werden, der Abstand 22 der Zündeinheit 20 zur Targetkathode 10 kann gegenüber einem Abstand einer nicht-planaren Zündeinheit zur Targetkathode 10 kleiner gewählt werden. Dadurch wird die Zündsicherheit deutlich erhöht und das Beschichtungsverfahren läuft insgesamt zuverlässiger.

Eine zweite Ausführungsform der Zündeinheit 20 zeigt die Figur 3, bei der die Isolatorkeramik vorteilhafterweise zweiteilig aufgebildet ist. Der erste Teil wird, wie aus der ersten Ausführungsform bekannt, durch eine planare Isolatorkeramik 35 gebildet. Der zweite Teil der Isolatorkeramik ist eine keramische Ummantelung 37, die sowohl die Rückseite 40 als auch die Seitenflächen 45, 50 der Zündeinheit 20 abdeckt. Dadurch wird sichergestellt, dass nur an der nicht mit der keramischen Ummantelung 37 abgedeckten Stirnseite 55 ein Zündfunke zwischen den zwei planaren Elektroden 25, 30 entsteht. Zur besseren Unterstützung des Zündvorgangs ist die Zündeinheit 20 zudem mit der Stirnseite 55, an der die Zündung erfolgt, zur Targetkathode 10 unter einem bestimmten Winkel 58 zwischen 45° und 90°geneigt (siehe auch Fig. 1).

Weiter ist in dieser bevorzugten Ausführungsform die Isolatorkeramik 35 der Zündeinheit 20 an der Stirnseite 55 mit einem elektrisch leitfähigen Material 60 beschichtet. Beim Anlegen eines Strompulses an der Zündeinheit 20 resultiert dann ein zur Targetkathode 10 gerichteter Strompfad, da teilweise das leitfähige Material 60 der Isolatorkeramik 35 verdampft und ein hochionisiertes Plasma auf die Targetkathode 10 beschleunigt wird. Dieser aus Plasma gebildeter Strompfad ermöglicht wiederum einen weiteren Strompfad zur eigentlichen Hauptentladung von der Targetkathode 10 zur Anode 5. Der teilweise Verbrauch des leitfähigen Materials 60 auf der Isolatorkeramik 35 wird während der Hauptentladung durch eine erneute Beschichtung kompensiert und so die leitfähige Beschichtung regeneriert. Dieser Vorgang gewährleistet die Dauerstabilität der Zündeinheit 20 auch im Betrieb über eine längere Zeit.

Für eine zuverlässige Zündung sollte die Polung der Zündelektroden 25, 30 derart angelegt sein, dass eine maximale Potentialdifferenz zwischen der Zündeinheit 20 und der Targetkathode 10 erzeugt wird. Hierfür wird die der Targetkathode 10 näher angeordnete metallische Elektrode 30 mit einer positiven, die der Targetkathode 20 entfernter angeordnete metallische Elektrode 25 mit einer negativen Spannung beaufschlagt.

Weiter ist für eine homogene Abtragung des Targetmaterials bzw. eine homogene Beschichtung eines Werkstückes die Anordnung der erfindungsgemäßen planaren Zündeinheiten 20 bezüglich der Targetkathode 10 wichtig. In Figur 4 ist eine Targetkathode 10 in Draufsicht dargestellt, wobei mehrere Zündeinheiten 20 am Rand der Targetkathode 10 angeordnet sind. Um die Hauptentladung gleichmäßig verteilt an verschiedenen Orten der Targetfläche lokalisiert zu zünden, ordnet man mehrere Zündeinheiten 20 derart entlang des Targetrandbereichs an, dass die Gesamtwirkung der einzelnen Zündeinheiten 20 zu einer optimalen, d. h. homogenen Abträgung über den gesamten Bereich der Targetkathode 10 führt. Diese Vorgehensweise wird ermöglicht durch einen sowohl variierbaren Abstand 65 zwischen den Zündeinheiten 20 als auch durch die Wahlmöglichkeit, geeignete Zündeinheiten 20 mit variierender Länge 70 einsetzen zu können. Bisher bekannte, unerwünschte Randeffekte wie die abnehmende Schichtdicke der Beschichtung am oberen und unteren Bereich der Targetfläche können durch einen engeren Abstand 65 der Zündeinheiten 20 in den entsprechenden Bereichen ausgeglichen werden.

Ein weiterer Vorteil der planaren Zündeinheiten 20 in oben beschriebener Anordnung ergibt sich aus der Möglichkeit, auf eine einfache Weise eine gemeinsame, durchgehende Basiselektrode 75 einzuführen, die beispielsweise alle negativ gepolten Elektroden 25 der einzelnen Zündeinheiten 20 miteinander verbindet und somit elektrisch kontaktiert.

Solch eine gemeinsame, durchgehende Basiselektrode 75 bietet außerdem die Möglichkeit, einen Kühlwasserkreislauf 80 in die Basiselektrode 75 zu integrieren. Wie aus Figur 1 und Figur 4 erkennbar, weist die Basiselektrode 75 einen integrierten Kühlwasserkreislauf 80 auf, der durch eine innere Kühlwasserleitung realisiert ist. Damit wird eine Kühlung aller Zündeinheiten 20 auf eine einfache Weise erzielt. Eine Kühlung der Zündeinheiten 20 ist für einen stabilen Dauerbetrieb deshalb erforderlich, weil die Zündeinheiten 20 einer hohen Wärmebelastung ausgesetzt sind, insbesondere bei hohen Zündfrequenzen.

## Patentansprüche

1. Vorrichtung zur Kohlenstoffabscheidung, insbesondere zur Abscheidung von tetraedrisch koordinierten amorphen Kohlenstoffschichten (ta-C), mittels einer gepulsten plasmagestützten Vakuum-Lichtbogenentladung, die eine Anode (5), eine aus Kohlenstoff bestehende Targetkathode (10), eine Pulsenergiequelle (15) und mindestens zwei Zündeinheiten (20) aufweist, wobei die Zündeinheiten (20) im Randbereich der Targetkathode (10) angeordnet sind, wobei die mindestens zwei Zündeinheiten (20) jeweils zwei planare, zueinander parallel angeordnete metallische Elektroden (25, 30) umfassen, wobei im Zwischenraum zwischen den Elektroden (25, 30) eine planare Isolatorkeramik (35) angeordnet ist,
**dadurch gekennzeichnet,**
**dass** mindestens eine der Zündeinheiten (20) auf der Rückseite (40) und auf zwei Seitenflächen (45, 50) mit einer keramischen Ummantelung (37) abgedeckt ist.

2. Vorrichtung nach Anspruch 1,
**dadurch gekennzeichnet,**
**dass** mindestens eine der Zündeinheiten (20) mit der Stirnseite (55), an der die Zündung erfolgt, zur Targetkathode (10) unter einem Winkel (58) zwischen 45° und 90° geneigt ist.

3. Vorrichtung nach einem der Ansprüche 1 oder 2,
**dadurch gekennzeichnet,**
**dass** die Isolatorkeramik (35) der Zündeinheit (20) an der Stirnseite (55) mit einem elektrisch leitfähigen Material (60) beschichtet ist.

4. Vorrichtung nach einem der Ansprüche 1 bis 3,
**dadurch gekennzeichnet,**
**dass** zur homogenen Abscheidung über den gesamten Bereich der Targetkathode (10) der Abstand (65) zwischen den mindestens zwei Zündeinheiten (20) und/oder die Länge (70) der Zündeinheiten (20) variierbar sind.

5. Vorrichtung nach einem der Ansprüche 1 bis 4,
**dadurch gekennzeichnet,**
**dass** die der Targetkathode (20) näher angeordnete metallische Elektrode (30) mit einer positiven, die der Targetkathode (20) entfernter angeordnete metallische Elektrode (25) mit einer negativen Spannung beaufschlagt wird.

6. Vorrichtung nach einem der Ansprüche 1 bis 5,
**dadurch gekennzeichnet,**
**dass** die mindestens zwei Zündeinheiten (20) eine gemeinsame, durchgehende Basiselektrode (75) aufweisen.

7. Vorrichtung nach Anspruch 6,
**dadurch gekennzeichnet,**
**dass** die gemeinsame Basiselektrode (75) durch einen Kühlwasserkreislauf (80) gekühlt wird.

## Claims

1. Device for carbon deposition, in particular for the deposition of tetrahedrally coordinated amorphous carbon layers (ta-C), by means of a pulsed plasmaenhanced vacuum arc discharge, which device comprises an anode (5), a target cathode (10) consisting of carbon, a pulsed energy source (15), and at least two ignition units (20), the ignition units (20) being arranged in the edge region of the target cathode (10), the at least two ignition units (20) respectively comprising two planar metallic electrodes (25, 30) arranged parallel to one another, a planar ceramic insulator element (35) being arranged in the intermediate space between the electrodes (25, 30), **characterized in that** at least one of the ignition units (20) is covered on the rear side (40) and on two side faces (45, 50) by a ceramic casing (37).

2. Device according to Claim 1, **characterized in that** at least one of the ignition units (20) is inclined with the end face (55), at which the ignition takes place, in relation to the target cathode (10) at an angle (58) of between 45° and 90°.

3. Device according to either of Claims 1 and 2, **characterized in that** the ceramic insulator element (35) of the ignition unit (20) is coated on the end face (55) with an electrically conductive material (60).

4. Device according to one of Claims 1 to 3, **characterized in that**, for homogeneous deposition over the entire region of the target cathode (10), the distance (65) between the at least two ignition units (20) and/or the length (70) of the ignition units (20) is/are variable.

5. Device according to one of Claims 1 to 4, **characterized in that** the metallic electrode (30) arranged closer to the target cathode (10) is subjected to a positive voltage, the metallic electrode (25) arranged further away from the target cathode (10) is subjected to a negative voltage.

6. Device according to one of Claims 1 to 5, **characterized in that** the at least two ignition units (20) have a common, continuous base electrode (75).

7. Device according to Claim 6, **characterized in that** the common base electrode (75) is cooled by a cooling water circuit (80).

## Revendications

1. Dispositif de séparation du carbone, notamment de séparation de couches de carbone amorphes tétraédriques coordonnées (ta-C) au moyen d'une décharge en arc sous vide pulsée assistée par plasma, lequel présente une anode (5), une cathode cible (10) constituée de carbone, une source d'énergie pulsée (15) et au moins deux unités d'amorçage (20), les unités d'amorçage (20) étant disposées dans la zone de bordure de la cathode cible (10), les au moins deux unités d'amorçage (20) comprenant respectivement deux électrodes (25, 30) métalliques planes disposées en parallèle l'une à l'autre, un isolateur céramique plan (35) étant disposé dans l'espace intermédiaire entre les électrodes (25, 30),
**caractérisé en ce**
**qu'**au moins l'une des unités d'amorçage (20) est recouverte d'un enrobage céramique (37) sur le côté arrière (40) et sur deux surfaces latérales (45, 50).

2. Dispositif selon la revendication 1, **caractérisé en ce qu'**au moins l'une des unités d'amorçage (20) est inclinée avec le côté frontal (55), là où a lieu l'amorçage, d'un angle (58) compris entre 45° et 90° par rapport à la cathode cible (10).

3. Dispositif selon l'une des revendications 1 ou 2, **caractérisé en ce que** l'isolateur céramique (35) de l'unité d'amorçage (20) est revêtu sur le côté frontal (55) d'un matériau électriquement conducteur (60).

4. Dispositif selon l'une des revendications 1 à 3, **caractérisé en ce que** pour une séparation homogène sur toute la zone de la cathode cible (10), l'écart (65) entre les au moins deux unités d'amorçage (20) et/ou la longueur (70) des unités d'amorçage (20) sont variables.

5. Dispositif selon l'une des revendications 1 à 4, **caractérisé en ce que** l'électrode métallique (30) la plus proche de la cathode cible (10) est soumise à une tension positive et l'électrode métallique (25) la plus éloignée de la cathode cible (10) est soumise à une tension négative.

6. Dispositif selon l'une des revendications 1 à 5, **caractérisé en ce que** les au moins deux unités d'amorçage (20) présentent une électrode de base (75) commune continue.

7. Dispositif selon la revendication 6, **caractérisé en ce que** l'électrode de base (75) commune est refroidie par un circuit d'eau de refroidissement (80).
